# EUROPÄISCHE PATENTSCHRIFT

(11) **EP 4 410 063 B1**
(45) Veröffentlichungstag und Bekanntmachung des Hinweises auf die Patenterteilung: **15.10.2025**
(21) Anmeldenummer: 22765483.7
(22) Anmeldetag: 12.08.2022
(51) Int. Cl.: H05K 7/14, H05K 7/20

(54) **LEISTUNGSMODUL, INSBESONDERE FÜR EINE LEISTUNGSELEKTRONIK EINES FAHRZEUGS**
POWER MODULE, IN PARTICULAR FOR POWER ELECTRONICS OF A VEHICLE
MODULE DE PUISSANCE, EN PARTICULIER POUR L'ÉLECTRONIQUE DE PUISSANCE D'UN VÉHICULE

(30) Priorität: 27.09.2021 DE 102021210770
(43) Veröffentlichungstag der Anmeldung: 07.08.2024
(73) Patentinhaber: Robert Bosch GmbH, 70442 Stuttgart (DE)
(72) Erfinder: DIKMENLI, Erdogan, 71636 Ludwigsburg (DE); VASCONCELOS ARAUJO, Samuel, 73728 Esslingen am Necker (DE); EGGER, Christian, 70195 Stuttgart (DE); FRANK, Alexander, 71083 Herrenberg (DE); LORENZ, Marco, 71254 Ditzingen (DE)
(86) Internationale Anmeldenummer: PCT/EP2022/072666
(87) Internationale Veröffentlichungsnummer: WO 2023/046365

(56) Entgegenhaltungen:
- DE-A1- 102019 111 111
- DE-A1- 102019 203 399

## Beschreibung

Die Erfindung geht aus von einem Leistungsmodul, insbesondere für eine Leistungselektronik eines Fahrzeugs. Gegenstand der vorliegenden Erfindung sind auch eine Leistungselektronik für ein Fahrzeug, mit einem solchen Leistungsmodul, und ein Fahrzeug mit einer solchen Leistungselektronik.

Leistungshalbleiter in Leistungselektroniken für Fahrzeuge mit Elektroantrieb oder mit Hybridantrieb führen hohe elektrische Ströme. Die durch Leit- und Schaltverluste entstehende Verlustwärme, welche über eine sehr kleine Fläche abgeführt werden muss, führt zu Wärmestromdichten bis 1000 W/cm². Zur effizienten Kühlung werden die Leistungssubstrate, welche die Leistungshalbleiter tragen, meist durch Kühler gekühlt, welche flüssiges Kühlmittel führen. Dabei wird die Wärme zwischen den zu kühlenden Halbleitern und der wärmeübertragenden Fläche (Kontaktfläche Kühler-Kühlmittel) ausschließlich durch Wärmeleitung übertragen. Die maximal zulässige Halbleitertemperatur ist dabei versagenskritisch, weshalb eine Minimierung des thermischen Widerstands zwischen Halbleiter und Kühlmittel vorteilhaft ist. Dies wird unter anderem dadurch erreicht, dass die an den Halbleitern anfallende Verlustwärme durch Wärmeleitung auf eine größere Fläche verteilt wird. Teil des Schichtaufbaus, durch den die Wärme geleitet wird, des sogenannten thermischen Stacks, ist eine Dielektrikum (z.B. eine Keramik oder ein Polymer), um das Kühlmittel von den spannungsführenden Bauteilen (Leistungshalbleiter und Stromführung) galvanisch zu trennen.

Aus der DE 10 2019 203 399 A1 ist eine elektrische Stromschienenanordnung mit einer ersten, zweiten und dritten, jeweils elektrisch bestrombaren Stromschiene bekannt, welche elektrisch gegeneinander isoliert sind. Jede dieser drei Stromschienen ist als von einem Fluid durchströmbarer Fluidkanal ausgebildet, so dass von den drei Stromschienen ein erster, zweiter und dritter Fluidkanal gebildet ist. Hierbei umfasst die Stromschienenanordnung einen Umlenkverteiler zum Verteilen des Fluids auf den zweiten und dritten Fluidkanal nach dem Durchströmen des ersten Fluidkanals. Die erste Stromschiene wird von einem elektrischen Wechselstrom und die zweite und dritte Stromschiene werden von einem elektrischen Gleichstrom durchströmt. Die erste Stromschiene ist mittels wenigstens einer elektrischen Isolation in einen ersten und in wenigstens einen zweiten Stromschienenabschnitt unterteilt, so dass die wenigstens zwei Stromschienenabschnitte elektrisch gegeneinander isoliert sind. Zudem weist die elektrische Stromschienenanordnung wenigstens eine elektronische Schaltungsanordnung auf, welche mehrere als Halbleiterschalter umfasst und elektrisch mit der ersten, zweiten und dritten Stromschiene verbunden ist. Eine solche Schaltungsanordnung kann beispielsweise ein elektrischer Inverter oder Wechselrichter sein.

### Offenbarung der Erfindung

Das Leistungsmodul mit den Merkmalen des unabhängigen Patentanspruchs 1 und die Leistungselektronik mit den Merkmalen des unabhängigen Patentanspruchs 12 sowie das Fahrzeug mit den Merkmalen des unabhängigen Patentanspruchs 14 haben jeweils den Vorteil, dass durch die Verwendung eines dielektrischen Fluids der thermische Widerstand der einzelnen Leistungsmodul signifikant verbessert werden kann. Bei der Verwendung des dielektrischen Fluids ist es möglich, auf die keramische Schicht zur elektrischen Isolation zwischen Ladungsträgern und Kühlmedium zu verzichten. Dadurch kann der Aufbau verkleinert und der thermische Widerstand, speziell mit Hinblick auf die schlechten Wärmeleitungseigenschaften dieser Schicht erheblich reduziert werden. Als dielektrisches Fluid können beispielsweise spezielle Kühlmittel oder Getriebeöle verwendet werden.

Ausführungsformen der Erfindung erlauben es, Leistungsmodule mit erheblich höherer Leistungsdichte und kompaktem Bauvolumen zu realisieren. Dies wird durch eine erhebliche Reduktion von bis zu 50% des thermischen Widerstands im Vergleich zu einem herkömmlichen kühlmittelgekühlten Aufbau mit isolierender Keramikschicht ermöglicht. Dadurch kann entweder die Chipfläche der einzelnen Leistungshalbleitern (35%-40%) und die damit verbundenen Kosten verkleinert werden, oder die Betriebstemperatur gesenkt und die Verluste reduziert werden. Zudem erlauben Ausführungsformen der Erfindung eine Modularisierung des Leistungselektronikaufbaus. Hierbei stellen die einzelnen Leistungsmodule eigenständige Einzelsegmente der Leistungselektronik dar. Durch die steckbaren Fluidanschlüsse in Kombination mit den steckbaren elektrischen Kontaktanschlüssen können die einzelnen Leistungsmodule einfach durch Zusammenstecken miteinander verbunden werden, so dass eine Skalierung der Leistungsklasse ermöglicht wird. Bei einer Verwendung der Leistungselektronik als Inverter bilden die einzelnen Leistungsmodule eigenständige Invertersegmente ab, so dass sich die realisierbaren Kommutierungszellen aufgrund der kompakten Bauweise von Leistungsmodul und Kühler flexibel in einem Leistungsinverter (DC/AC Wandler) anordnen lassen.

Weiterhin kann durch die Kombination einer durch das dielektrische Fluid gekühlten Leistungselektronik und eines durch das dielektrische Fluid gekühlten elektrischen Antriebs und/oder Getriebes auf Kühlmittel, wie beispielsweise Wasser/Glykol, in einer elektrischen Antriebsachse verzichtet werden. Eine Rückkühlung des dielektrischen Fluids erfolgt beispielsweise durch einen luftgekühlten Wärmeübertrager. Weiterhin wird durch die sehr kleine Bauweise und den modularen Aufbau der Leistungselektronik eine Miniaturisierung und Leistungsskalierung ermöglicht.

Ausführungsformen der vorliegenden Erfindung stellen ein Leistungsmodul, insbesondere für eine Leistungselektronik eines Fahrzeugs zur Verfügung, welches zwei Gleichstromstromschienen und drei Phasenstromschienen, welche zwischen den beiden Gleichstromschienen angeordnet sind, und mehrere Leistungshalbleiter umfasst, welche jeweils zwischen einer der Gleichstromschienen und einer der Phasenstromschienen angeordnet sind. Die Gleichstromstromschienen und die Phasenstromschienen sind gegeneinander elektrisch isoliert sind und weisen jeweils mindestens einen von einem dielektrischen Fluid durchströmten Kühlkanal auf. Hierbei weisen die Gleichstromstromschienen und die Phasenstromschienen an beiden offenen Enden jeweils mindestens einen steckbaren elektrischen Kontaktanschluss und mindestens einen steckbaren Fluidanschluss auf, welche jeweils einen kombinierten Steckverbindungsanschluss ausbilden, so dass mehrere Leistungsmodule mittels der kombinierten Steckverbindungen fluiddicht miteinander verbindbar sind.

Durch die kombinierten Steckverbindungsanschlüsse können bei der Verbindung von mehreren Leistungsmodulen in einem Arbeitsgang die Fluidverbindungen zwischen den korrespondierenden Kühlkanälen und die elektrischen Verbindungen zwischen den korrespondierenden Gleichstromstromschienen und Phasenstromschienen realisiert werden. Durch die Ausführung als fluiddichte Steckverbindungen kann eine starke Querschnittsverengung der Kühlkanäle vermieden werden, welche zu einem großen Druckverlust führen würde. Weiterhin können die elektrischen Verbindungen mit einer ausreichend großen Kontaktoberfläche realisiert werden.

Zudem wird eine Leistungselektronik für ein Fahrzeug, mit einer Auswerte- und Steuereinheit und mindestens einem solchen Leistungsmodul vorgeschlagen. Hierbei sind Steuersignalanschlüsse der Leistungshalbleiter elektrisch mit der Auswerte- und Steuereinheit verbunden.

Des Weiteren wird ein Fahrzeug mit einer solchen Leistungselektronik und einem Kühlkreislauf vorgeschlagen, in welchem zur Kühlung von Fahrzeugaggregaten ein dielektrisches Fluid geführt ist. Hierbei ist die Leistungselektronik über korrespondierende Schnittstelleneinheiten fluidisch mit dem Kühlkreislauf verbunden.

Unter der Auswerte- und Steuereinheit kann vorliegend ein elektrisches Gerät, wie beispielsweise ein Steuergerät, insbesondere ein Antriebssteuergerät, verstanden werden, welches erfasste Sensorsignale verarbeitet bzw. auswertet, um entsprechende Phasenströme einzustellen bzw. zu regeln. Die Auswerte- und Steuereinheit kann mindestens eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Auswerte- und Steuereinheit beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind. Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert ist und zur Durchführung der Auswertung verwendet wird, wenn das Programm von der Auswerte- und Steuereinheit ausgeführt wird.

Durch die in den abhängigen Ansprüchen aufgeführten Maßnahmen und Weiterbildungen sind vorteilhafte Verbesserungen des im unabhängigen Patentanspruch 1 angegebenen Leistungsmoduls und der im unabhängigen Patentanspruch 12 angegebenen Leistungselektronik möglich.

In vorteilhafter Ausgestaltung des Leistungsmoduls können die einzelnen Leistungshalbleiter als Halbleiterschalter ausgeführt sein. Hierbei kann jeweils ein erster Leistungsanschluss der Leistungshalbleiter direkt mit einer korrespondierenden Gleichstromstromschiene und ein zweiter Leistungsanschluss der Leistungshalbleiter kann über einen Abstandshalter mit einer korrespondierenden Phasenstromschiene verbunden sein. Durch diese gute thermische Verbindung zwischen den Leistungshalbleitern und den Kühlkanälen kann die Chipfläche der Leistungshalbleiter reduziert oder die Betriebstemperatur gesenkt werden.

In weiterer vorteilhafter Ausgestaltung des Leistungsmoduls können die Gleichstromstromschienen jeweils drei Kühlkanäle aufweisen, welche jeweils parallel zu den Kühlkanälen der drei Phasenstromschienen verlaufen können. Besonders vorteilhaft ist, dass ein erster Leistungshalbeiter zwischen einem ersten Kühlkanal einer ersten Gleichstromstromschiene und dem Kühlkanal einer ersten Phasenstromschiene angeordnet sein kann. Ein zweiter Leistungshalbeiter kann zwischen einem ersten Kühlkanal einer zweiten Gleichstromstromschiene und dem Kühlkanal der ersten Phasenstromschiene angeordnet sein. Ein dritter Leistungshalbeiter kann zwischen einem zweiten Kühlkanal der ersten Gleichstromstromschiene und dem Kühlkanal einer zweiten Phasenstromschiene angeordnet sein. Ein vierter Leistungshalbeiter kann zwischen einem zweiten Kühlkanal der zweiten Gleichstromstromschiene und dem Kühlkanal der zweiten Phasenstromschiene angeordnet sein. Ein fünfter Leistungshalbeiter kann zwischen einem dritten Kühlkanal der ersten Gleichstromstromschiene und dem Kühlkanal einer dritten Phasenstromschiene angeordnet sein. Ein sechster Leistungshalbeiter kann zwischen einem dritten Kühlkanal der zweiten Gleichstromstromschiene und dem Kühlkanal der dritten Phasenstromschiene angeordnet sein. Da die Kühlkanäle der Phasenstromschienen Verlustwärme von Leistungshalbleitern auf beiden Seiten der Phasenstromschienen abführen und die Kühlkanäle der Gleichstromstromschienen nur eine einseitige Wärmebelastung aufweisen, kann die Kanalhöhe der Kühlkanäle der Phasenschiene höher sein als die Kanalhöhe der Kühlkanäle der Gleichstromstromschienen. Vorzugsweise können die Kühlkanäle der Phasenstromschienen doppelt so hoch wie die Kanalhöhe der Gleichstromstromschienen sein. Auf diese Weise kann ein möglichst homogenes Temperaturprofil erreicht werden.

In weiterer vorteilhafter Ausgestaltung des Leistungsmoduls können die einzelnen Kühlkanäle im Bereich der Leistungshalbleiter jeweils eine Kühlgeometrie aufweisen. Die Kühlgeometrie kann beispielsweise mehrere Kühlstifte oder Turbulatoren oder Vorsprünge oder Rippen umfassen. Durch die Kühlgeometrie kann eine gleichmäßige Verteilung des dielektrischen Fluids bezogen auf die Kanalhöhe und dadurch ein besserer Wärmeübertragung erreicht werden. Hierbei können die Abmessungen und Abstände der Kühlstifte oder Turbulatoren oder Vorsprünge oder Rippen in allen Kanälen identisch ausgeführt werden, um eine identische Druckverlustcharakteristik zu erreichen.

In weiterer vorteilhafter Ausgestaltung des Leistungsmoduls können die Gleichstromstromschienen und die Phasenstromschienen unter Freilassung der steckbaren Fluidanschlüsse und der steckbaren elektrischen Kontaktanschlüsse von einer Umhüllung umgeben sein. Das Leistungsmodul kann beispielsweise in einem Spritzpressprozess mit einem Transfermold vergossen werden. Damit kein Moldmaterial in die Kühlkanäle einströmen kann, können die Fluidanschlüsse vor dem Spritzpressprozess geschlossen sein. Nach dem Spritzpressprozess kann die abdeckende Schicht beispielsweise durch Fräsen entfernt werden.

In weiterer vorteilhafter Ausgestaltung des Leistungsmoduls können seitlich an den Gleichstromstromschienen Kondensatoranschlüsse angeordnet und aus der Umhüllung herausgeführt sein, welche mit Kondensatoren kontaktiert sind, so dass die einzelnen Kondensatoren elektrisch jeweils zwischen den beiden Gleichstromschienen angeordnet sind. Des Weiteren können Steuersignalanschlüsse der Leistungshalbleiter seitlich aus der Umhüllung herausgeführt sein, welche mit einer Auswerte- und Steuereinheit kontaktierbar sind. Die Steuersignalanschlüsse können beispielsweise als Stanzgitter ausgeführt sein. Um den Spritzpressprozess zu vereinfachen, können die seitlich angeordneten Kondensatoranschlüsse und die seitlich angeordneten Steuersignalanschlüsse in einer gemeinsamen Anschlussebene angeordnet sein, damit das Werkzeug geschlossen werden kann. Zudem können die Kondensatoren mit einer Umhüllung separat vergossenen werden und nach dem Spritzpressen und dem Öffnen der Kühlkanäle mit den Kondensatoranschlüssen des Leistungsmoduls verbunden werden. Durch diese Prozessreihenfolge können die Komponenten separat im Fertigungsprozess geprüft werden. Die Kondensatoren werden über die Kondensatoranschlüsse mittels Wärmeleitung durch den integrierten Kühlkanal der Gleichstromstromschiene mitgekühlt.

In weiterer vorteilhafter Ausgestaltung des Leistungsmoduls können die Gleichstromstromschienen und die Phasenstromschienen als 3D-Druckbauteile oder als Stanz-Biegeteile ausgeführt sein. Für die Gleichstromstromschienen und die Phasenstromschienen wird ein druckbares Metall, wie beispielsweise Kupfer (Cu) oder Kupfergraphit (Cu-C) verwendet. Die Verbindung der Leistungshalbleiter mit der Oberfläche der Gleichstromstromschienen oder mit der Oberfläche der Abstandshalter kann beispielsweise mittels Sintern oder Löten hergestellt werden. Die Verbindung der Oberfläche der Phasenstromschienen mit den Abstandshaltern kann beispielsweise über Sintern hergestellt werden. Die Abstandshalter können vorzugsweise aus Kupfer hergestellt sein. Unter einem 3D-Druckverfahren soll ein Verfahren mit einem Auftrageprozess und einem Härteprozess verstanden werden, z.B. selektives Lasersintern, selektives Elektronenstrahlschmelzen oder Stereolithographie.

In vorteilhafter Ausgestaltung der Leistungselektronik können mehrere Leistungsmodule, welche jeweils ein Invertersegment ausbilden, durch Steckerbindungen miteinander verbunden sein und einen Gesamtinverter mit einer höheren Leistungsdichte ausbilden. Hierbei kann jedes Invertersegment eine vollständige B6-Brücke ausbilden und mit der Auswerte- und Steuereinheit und den Kondensatoren einen kompletten Inverter darstellen. Hierbei umfasst jede Phasenstromschiene der einzelnen Invertersegmente jeweils einen als Feldeffekttransistor ausgeführten Halbleiterschalter für eine "Highside" und einen als Feldeffekttransistor ausgeführten Halbleiterschalter für eine "Lowside". Die Auswerte- und Steuereinheit kann auf die Umhüllung der montierten Leistungselektronik montiert sein.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

Kurze Beschreibung der Zeichnungen
Fig. 1 zeigt eine schematische perspektivische Darstellung eines Ausführungsbeispiels eines erfindungsgemäßen Leistungsmoduls von vorn.
Fig. 2 zeigt eine schematische Schnittdarstellung des erfindungsgemäßen Leistungsmoduls aus Fig. 1 ohne Umhüllung und Kondensatoren.
Fig. 3 zeigt eine schematische perspektivische Darstellung des erfindungsgemäßen Leistungsmoduls aus Fig. 1 von hinten.
Fig. 4 zeigt eine schematische Draufsicht auf ein Ausführungsbeispiels einer erfindungsgemäßen Leistungselektronik mit drei Leistungsmodulen aus Fig. 1 bis 3.
Fig. 5 zeigt eine schematische perspektivische Teilschnittdarstellung eines Ausschnitts der erfindungsgemäßen Leistungselektronik aus Fig. 4.
Fig. 6 zeigt eine schematische Darstellung eines Ausführungsbeispiels eines Kühlkreislaufs für ein erfindungsgemäßes Fahrzeug mit der Leistungselektronik aus Fig. 4 und 5.

### Ausführungsformen der Erfindung

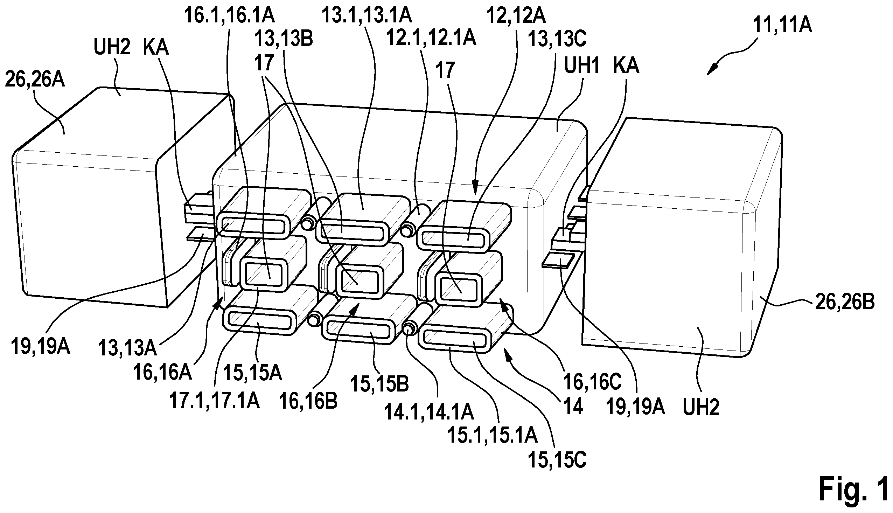

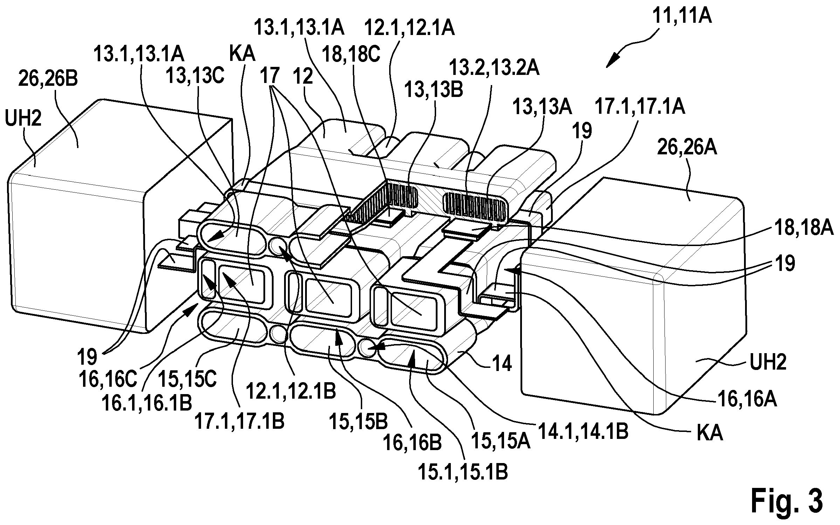

Wie aus Fig. 1 bis 6 ersichtlich ist, umfasst das dargestellte Ausführungsbeispiel eines erfindungsgemäßen Leistungsmoduls 11, 11A, 11B, 11C, insbesondere für eine Leistungselektronik 10 eines Fahrzeugs 1, zwei Gleichstromstromschienen 12, 12A, 12B, 12C, 14, 14A, 14B, 14C und drei Phasenstromschienen 16, 16A, 16B, 16C, welche zwischen den beiden Gleichstromstromschienen 12, 12A, 12B, 12C, 14, 14A, 14B, 14C angeordnet sind, und mehrere Leistungshalbleiter 18, 18A, 18B, 18C, 18D, 18E, 18F, welche jeweils zwischen einer der Gleichstromstromschienen 12, 12A, 12B, 12C, 14, 14A, 14B, 14C und einer der Phasenstromschienen 16, 16A, 16B, 16C angeordnet sind. Die Gleichstromstromschienen 12, 12A, 12B, 12C, 14, 14A, 14B, 14C und die Phasenstromschienen 16, 16A, 16B, 16C sind gegeneinander elektrisch isoliert und weisen jeweils mindestens einen von einem dielektrischen Fluid durchströmten Kühlkanal 13, 13A, 13B, 13C, 15, 15A, 15B, 15C, 17 auf. Hierbei weisen die Gleichstromstromschienen 12, 12A, 12B, 12C, 14, 14A, 14B, 14C und die Phasenstromschienen 16, 16A, 16B, 16C an beiden offenen Enden jeweils mindestens einen steckbaren elektrischen Kontaktanschluss 12.1, 14.1, 16.1 und mindestens einen steckbaren Fluidanschluss 13.1, 15.1, 17.1 auf, welche jeweils einen kombinierten Steckverbindungsanschluss ausbilden, so dass mehrere Leistungsmodule 11, 11A, 11B, 11C mittels Steckverbindungen fluiddicht miteinander verbindbar sind.

Im dargestellten Ausführungsbeispiel ist das Leistungsmodul 11, 11A, 11B, 11C als vollständige B6-Brücke ausgeführt und umfasst sechs als Halbleiterschalter bzw. Feldeffekttransistoren ausgeführte Leistungshalbleiter 18, 18A, 18B, 18C, 18D, 18E, 18F. Hierbei ist jeweils ein erster Leistungsanschluss der Leistungshalbleiter 18, 18A, 18B, 18C, 18D, 18E, 18F direkt mit einer korrespondierenden Gleichstromstromschiene 12, 12A, 12B, 12C, 14, 14A, 14B, 14C und ein zweiter Leistungsanschluss der Leistungshalbleiter 18, 18A, 18B, 18C, 18D, 18E, 18F ist über einen Abstandshalter mit einer korrespondierenden Phasenstromschiene 16, 16A, 16B, 16C verbunden. Die Abstandshalter sind im dargestellten Ausführungsbeispiel aus Kupfer gefertigt. Die Verbindung der Leistungshalbleiter 18, 18A, 18B, 18C, 18D, 18E, 18 zu den Gleichstromstromschienen 12, 12A, 12B, 12C, 14, 14A, 14B, 14C bzw. zu den Abstandshaltern erfolgt im dargestellten Ausführungsbeispiel mittels Sintern. Bei einem alternativen nicht dargestellten Ausführungsbeispiel werden die Leistungshalbleiter 18, 18A, 18B, 18C, 18D, 18E, 18 auf die Gleichstromstromschienen 12, 12A, 12B, 12C, 14, 14A, 14B, 14C bzw. die Abstandshalter gelötet. Die Verbindung der Phasenstromschienen 16, 16A, 16B, 16C zu den beidseitigen Kupferabstandshaltern wird durch Sintern hergestellt.

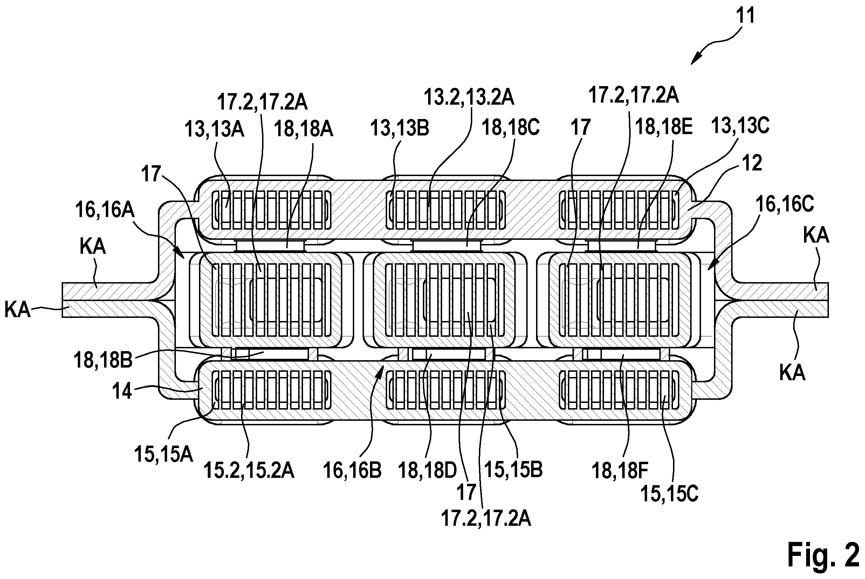

Wie aus Fig. 1 bis 5 weiter ersichtlich ist, weisen die beiden Gleichstromstromschienen 12, 12A, 12B, 12C, 14, 14A, 14B, 14C jeweils drei Kühlkanäle 13, 13A, 13B, 13C, 15, 15A, 15B, 15C, 17 auf, welche jeweils parallel zu den Kühlkanälen 17 der drei Phasenstromschienen 16, 16A, 16B, 16C verlaufen. Wie insbesondere aus Fig. 2 ersichtlich ist, ist im dargestellten Ausführungsbeispiel des Leistungsmoduls 11, 11A, 11B, 11C ein erster Leistungshalbeiter 18A zwischen einem ersten Kühlkanal 13A einer ersten Gleichstromstromschiene 12 und dem Kühlkanal 17 einer ersten Phasenstromschiene 16A angeordnet. Ein zweiter Leistungshalbeiter 18B ist zwischen einem ersten Kühlkanal 15A einer zweiten Gleichstromstromschiene 14 und dem Kühlkanal 17 der ersten Phasenstromschiene 16A angeordnet. Ein dritter Leistungshalbeiter 18C ist zwischen einem zweiten Kühlkanal 13B der ersten Gleichstromstromschiene 12 und dem Kühlkanal 17 einer zweiten Phasenstromschiene 16B angeordnet. Ein vierter Leistungshalbeiter 18D ist zwischen einem zweiten Kühlkanal 15B der zweiten Gleichstromstromschiene 14 und dem Kühlkanal 17 der zweiten Phasenstromschiene 16A angeordnet. Ein fünfter Leistungshalbeiter 18E ist zwischen einem dritten Kühlkanal 13C der ersten Gleichstromstromschiene 12 und dem Kühlkanal 17 einer dritten Phasenstromschiene 16C angeordnet. Ein sechster Leistungshalbeiter 18F ist zwischen einem dritten Kühlkanal 15C der zweiten Gleichstromstromschiene 14 und dem Kühlkanal 17 der dritten Phasenstromschiene 16C angeordnet.

Wie insbesondere aus Fig. 2, 3 und 5 ersichtlich ist, weisen die einzelnen Kühlkanäle 13, 13A, 13B, 13C, 15, 15A, 15B, 15C, 17 im Bereich der Leistungshalbleiter 18, 18A, 18B, 18C, 18D, 18E, 18F jeweils eine Kühlgeometrie 17.1 auf. Im dargestellten Ausführungsbeispiel umfasst die Kühlgeometrie 17.1 mehrere Kühlstifte 17.1A, welche auch als "Pin Fins" bezeichnet werden. Bei alternativen nicht dargestellten Ausführungsbeispielen der Kühlkanäle 13, 13A, 13B, 13C, 15, 15A, 15B, 15C, 17 kann die Kühlgeometrie 17.1 Turbulatoren oder Vorsprünge oder Rippen umfassen. Wie aus Fig. 1 bis 5 weiter ersichtlich ist die Höhe der Kühlkanäle 17 der Phasenstromschienen 16, 16A, 16B, 16C doppelt so hoch wie die Höhe der Kühlkanäle 13, 13A, 13B, 13C, 15, 15A, 15B, 15C der Gleichstromstromschienen 12, 12A, 12B, 12C, 14, 14A, 14B, 14C, da die Verlustwärme der Leistungshalbleiter 18, 18A, 18B, 18C, 18D, 18E, 18F Leistungshalbleitern auf beiden Seiten der Kühlkanäle 17 der Phasenstromschienen 16, 16A, 16B, 16C abgeführt wird. Die Kühlkanäle 13, 13A, 13B, 13C, 15, 15A, 15B, 15C der Gleichstromstromschienen 12, 12A, 12B, 12C, 14, 14A, 14B, 14C haben nur eine einseitige Wärmebelastung. Die Durchmesser und Abstände der Kühlstifte 17.1A sind in allen Kühlkanälen 13, 13A, 13B, 13C, 15, 15A, 15B, 15C, 17 identisch.

Wie aus Fig. 1 weiter ersichtlich ist, sind die Gleichstromstromschienen 12, 12A, 14, 14A und die Phasenstromschienen 16, 16A, 16B, 16C unter Freilassung der steckbaren Fluidanschlüsse 13.1, 15.1, 17.1 und der steckbaren elektrischen Kontaktanschlüsse 12.1, 14.1, 16.1 von einer Umhüllung UH1 umgeben. Wie aus Fig. 1 weiter ersichtlich ist, sind an der dargestellten Vorderseite des Leistungsmoduls 11, 11A die steckbaren Fluidanschlüsse 13.1, 15.1, 17.1 als Steckkontakte 13.1A, 15.1A, 17.1A ausgeführt. Analog sind die steckbaren elektrischen Kontaktanschlüsse 12.1, 14.1, 16.1 ebenfalls als Steckkontakte 12.1A, 14.1A, 16.1A ausgeführt. An der Rückseite des Leistungsmoduls 11, 11A, 11B, 11C sind die steckbaren Fluidanschlüsse 13.1, 15.1, 17.1 als Steckeraufnahmen 13.1B, 15.1B, 17.1B ausgebildet. Die Steckeraufnahmen 13.1B, 15.1B, 17.1B der steckbaren Fluidanschlüsse 13.1, 15.1, 17.1 an der Rückseite des Leistungsmoduls 11, 11A und die Steckkontakte 12.1A, 14.1A, 16.1A der steckbaren Fluidanschlüsse 13.1, 15.1, 17.1 an der Vorderseite des Leistungsmoduls 11, 11A sind so ausgeführt und aufeinander abgestimmt, dass zwischen zwei miteinander verbundenen Leistungsmodulen 11, 11A, 11B, 11C fluiddichte Steckverbindungen zwischen den Steckkontakten 13.1A, 15.1A, 17.1A und den Steckeraufnahmen 13.1B, 15.1B, 17.1B der Kühlkanäle 13, 13A, 13B, 13C, 15, 15A, 15B, 15C, 17 ausgebildet sind. Analog sind die steckbaren elektrischen Kontaktanschlüsse 12.1, 14.1, 16.1 an der Rückseite des Leistungsmoduls 11, 11A ebenfalls als Steckeraufnahmen 12.1B, 14.1B, 16.1B ausgeführt. Die Steckeraufnahmen 12.1B, 14.1B, 16.1B der steckbaren elektrischen Kontaktanschlüsse 12.1, 14.1, 16.1 an der Rückseite des Leistungsmoduls 11, 11A und die Steckkontakte 12.1A, 14.1A, 16.1A der steckbaren elektrischen Kontaktanschlüsse 12.1, 14.1, 16.1 an der Vorderseite des Leistungsmoduls 11, 11A sind so ausgeführt und aufeinander abgestimmt, dass zwischen zwei miteinander verbundenen Leistungsmodulen 11, 11A, 11B, 11C Steckverbindungen mit einem möglichst kleinen ohmschen Übergangswiderstand zwischen den Steckkontakten 12.1A, 14.1A, 16.1A und den Steckeraufnahmen 12.1B, 14.1B, 16.1B der Gleichstromstromschienen 12, 12A, 12B, 12C, 14, 14A, 14B, 14C und der Phasenstromschienen 16, 16A, 16B, 16C ausgebildet sind.

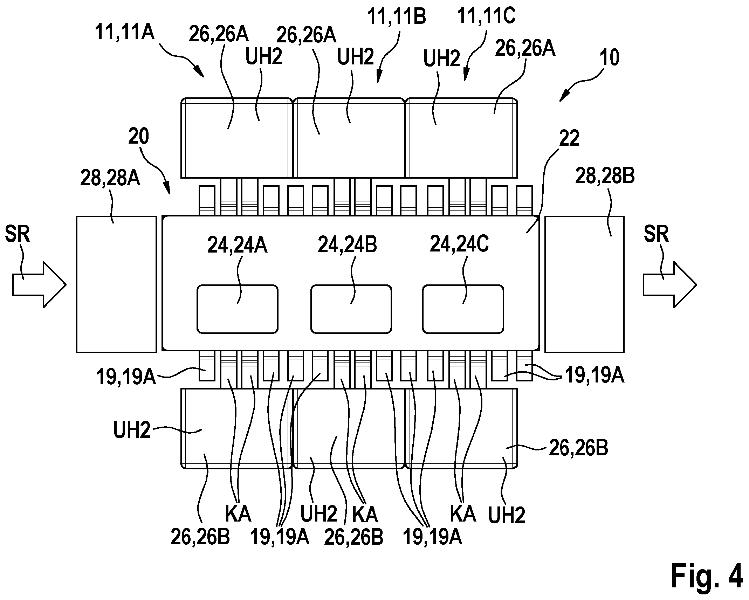

Wie aus Fig. 1 bis 3 weiter ersichtlich ist, sind seitlich an den Gleichstromstromschienen 12, 12A, 14, 14A Kondensatoranschlüsse KA angeordnet und aus der Umhüllung UH1 herausgeführt, welche mit Kondensatoren 26, 26A, 26B kontaktiert sind, so dass die einzelnen Kondensatoren 26,26A, 26B elektrisch jeweils zwischen den beiden Gleichstromstromschienen 12, 12A, 14, 14A angeordnet sind. Zudem sind Steuersignalanschlüsse 19 der Leistungshalbleiter 18, 18A, 18B, 18C, 18D, 18E, 18F seitlich aus der Umhüllung UH1 herausgeführt, welche mit einer in Fig. 4 dargestellten Auswerte- und Steuereinheit 20 kontaktierbar sind. Die seitlich angeordneten Kondensatoranschlüsse KA und die seitlich angeordneten Steuersignalanschlüsse 19 sind in einer gemeinsamen Anschlussebene angeordnet. Die Umhüllung UH1 wird in einem Spritzpressprozess mit einem Transfermold gegossen. Die Fluidanschlüsse 13.1, 15.1, 17.1 sind vor dem Spritzpressprozess geschlossen, damit kein Moldmaterial in die korrespondierenden Kühlkanäle 13, 13A, 13B, 13C, 15, 15A, 15B, 15C, 17 einströmen kann. Nach dem Spritzpressprozess wird die abdeckende Schicht entfernt. Die separat mit einer eigenen Umhüllung UH2 vergossenen Kondensatoren 26, 26A, 26B werden nach dem Spritzpressen und dem Öffnen der Kühlkanäle 13, 13A, 13B, 13C, 15, 15A, 15B, 15C, 17 mit den Kondensatoranschlüssen KA verbunden. Aufgrund der Wärmeleitung werden die Kondensatoren 26, 26A, 26B über die Kondensatoranschlüsse KA und die Gleichstromstromschienen 12, 12A, 12B, 12C, 14, 14A, 14B, 14C mitgekühlt. Im dargestellten Ausführungsbeispiel des Leistungsmoduls 11, 11A sind die Gleichstromstromschienen 12, 12A, 12B, 12C, 14, 14A, 14B, 14C und die Phasenstromschienen 16, 16A, 16B, 16C jeweils als 3D-Druckbauteile aus Kupfer ausgeführt. Selbstverständlich können auch andere druckfähige thermisch und elektrisch leitende Materialien zur Herstellung der Gleichstromstromschienen 12, 12A, 12B, 12C, 14, 14A, 14B, 14C und Phasenstromschienen 16, 16A, 16B, 16C verwendet werden. Zudem können die Gleichstromstromschienen 12, 12A, 12B, 12C, 14, 14A, 14B, 14C und Phasenstromschienen 16, 16A, 16B, 16C auch als Stanz-Biegeteile aus einem Metallblech hergestellt werden.

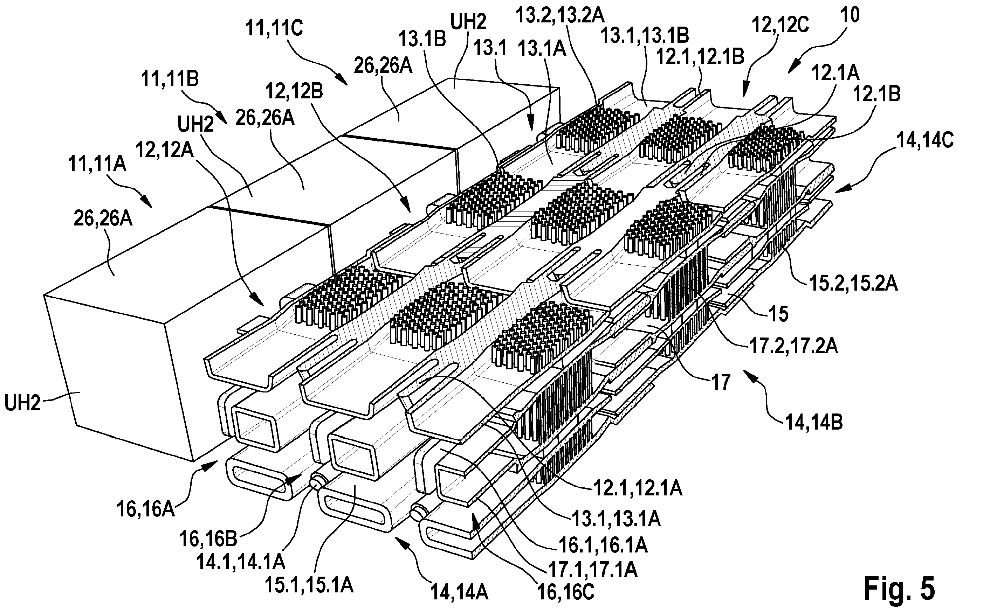

Wie aus Fig. 4 und 5 weiter ersichtlich ist, umfasst das dargestellte Ausführungsbeispiel der erfindungsgemäßen Leistungselektronik 10 für ein Fahrzeug 1 eine Auswerte- und Steuereinheit 20 und drei oben beschriebene Leistungsmodule 11A, 11B, 11C, welche über kombinierte Steckerverbindungen fluidisch und elektrisch miteinander verbunden sind. Die Auswerte- und Steuereinheit 20 ist auf die fertig vergossene und montierte Leistungselektronik 10 montiert.

Wie aus Fig. 4 und 5 weiter ersichtlich ist, sind die steckbaren elektrischen Kontaktanschlüsse 12.1, 14.1, 16.1 und die steckbaren elektrischen Kontaktanschlüsse 12.1, 14.1, 16.1 an der Vorderseite eines ersten Leistungsmoduls 11A mit einer als Eingangsschnittstelle 28A ausgeführten Schnittstelleneinheit 28 verbunden. Die steckbaren elektrischen Kontaktanschlüsse 12.1, 14.1, 16.1 und die steckbaren elektrischen Kontaktanschlüsse 12.1, 14.1, 16.1 an der Rückseite des ersten Leistungsmoduls 11A sind mit den steckbaren elektrischen Kontaktanschlüssen 12.1, 14.1, 16.1 und den steckbaren elektrischen Kontaktanschlüsse 12.1, 14.1, 16.1 an der Vorderseite eines zweiten Leistungsmoduls 11B verbunden. Die steckbaren elektrischen Kontaktanschlüsse 12.1, 14.1, 16.1 und die steckbaren elektrischen Kontaktanschlüsse 12.1, 14.1, 16.1 an der Rückseite des zweiten Leistungsmoduls 11B sind mit den steckbaren elektrischen Kontaktanschlüssen 12.1, 14.1, 16.1 und den steckbaren elektrischen Kontaktanschlüsse 12.1, 14.1, 16.1 an der Vorderseite eines dritten Leistungsmoduls 11C verbunden. Die steckbaren elektrischen Kontaktanschlüsse 12.1, 14.1, 16.1 und die steckbaren elektrischen Kontaktanschlüsse 12.1, 14.1, 16.1 an der Rückseite des dritten Leistungsmoduls 11A sind mit einer als Ausgangsschnittstelle 28B ausgeführten Schnittstelleneinheit 28 verbunden.

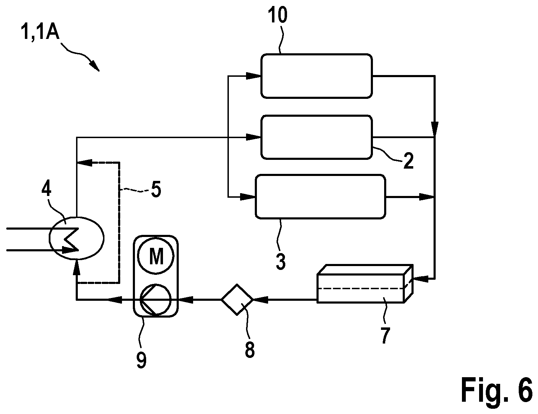

Die Eingangsschnittstelle 28A und/oder die Ausgangsschnittstelle 28B umfassen eine nicht näher dargestellte Gleichstromanbindung der Gleichstromstromschienen 12, 12A, 12B, 12C, 14, 14A, 14B, 14C und nicht näher dargestellte Mittel zur Anbindung der Kühlkanäle 13, 13A, 13B, 13C, 15, 15A, 15B, 15C, 17 an einen in Fig. 6 dargestellten Kühlkreislauf 1A des Fahrzeugs 1, in welchem das dielektrische Fluid in die durch Pfeile angedeutete Strömungsrichtung SR strömt. Hierbei ist eine erste Gleichstromschiene 12A des ersten Leistungsmoduls 11A und/oder eine erste Gleichstromschiene 12C des dritten Leistungsmoduls 11C mit einem Pluspol einer nicht dargestellten Gleichstromquelle verbunden. Eine zweite Gleichstromschiene 14A des ersten Leistungsmoduls 11A und/oder eine zweite Gleichstromschiene 14C des dritten Leistungsmoduls ist mit einem Minuspol der Gleichstromquelle verbunden. Zudem können Wechselsignale der drei Phasenstromschienen 16A, 16B, 16C durch die Eingangsschnittstelle abgegriffen werden. Des Weiteren ist die erste Gleichstromschiene 12A des ersten Leistungsmoduls 11A über die steckbaren elektrischen Kontaktanschlüsse 12.1 und die steckbaren Fluidanschlüsse 13.1 mit der ersten Gleichstromschiene 12B des zweiten Leistungsmoduls 11B verbunden. Die erste Gleichstromschiene 12B des zweiten Leistungsmoduls 11B ist über die steckbaren elektrischen Kontaktanschlüsse 12.1 und die steckbaren Fluidanschlüsse 13.1 mit der ersten Gleichstromschiene 12C des dritten Leistungsmoduls 11C verbunden. Die zweite Gleichstromschiene 14A des ersten Leistungsmoduls 11A ist über die steckbaren elektrischen Kontaktanschlüsse 14.1 und die steckbaren Fluidanschlüsse 15.1 mit der zweiten Gleichstromschiene 14B des zweiten Leistungsmoduls 11B verbunden. Die zweite Gleichstromschiene 14B des zweiten Leistungsmoduls 11B ist über die steckbaren elektrischen Kontaktanschlüsse 14.1 und die steckbaren Fluidanschlüsse 15.1 mit der zweiten Gleichstromschiene 14C des dritten Leistungsmoduls 11C verbunden. Die erste Phasenstromschiene 16A des ersten Leistungsmoduls 11A ist über die steckbaren elektrischen Kontaktanschlüsse 16.1 und die steckbaren Fluidanschlüsse 17.1 mit der ersten Phasenstromschiene 16A des zweiten Leistungsmoduls 11B verbunden. Die erste Phasenstromschiene 16A des zweiten Leistungsmoduls 11B ist über die steckbaren elektrischen Kontaktanschlüsse 16.1 und die steckbaren Fluidanschlüsse 17.1 mit der ersten Phasenstromschiene 16A des dritten Leistungsmoduls 11C verbunden. Die zweite Phasenstromschiene 16B des ersten Leistungsmoduls 11A ist über die steckbaren elektrischen Kontaktanschlüsse 16.1 und die steckbaren Fluidanschlüsse 17.1 mit der zweiten Phasenstromschiene 16B des zweiten Leistungsmoduls 11B verbunden. Die zweite Phasenstromschiene 16B des zweiten Leistungsmoduls 11B ist über die steckbaren elektrischen Kontaktanschlüsse 16.1 und die steckbaren Fluidanschlüsse 17.1 mit der zweiten Phasenstromschiene 16B des dritten Leistungsmoduls 11C verbunden. Die dritte Phasenstromschiene 16C des ersten Leistungsmoduls 11A ist über die steckbaren elektrischen Kontaktanschlüsse 16.1 und die steckbaren Fluidanschlüsse 17.1 mit der dritten Phasenstromschiene 16C des zweiten Leistungsmoduls 11B verbunden. Die dritte Phasenstromschiene 16C des zweiten Leistungsmoduls 11B ist über die steckbaren elektrischen Kontaktanschlüsse 16.1 und die steckbaren Fluidanschlüsse 17.1 mit der dritten Phasenstromschiene 16C des dritten Leistungsmoduls 11C verbunden.

Wie aus Fig. 4 weiter ersichtlich ist, sind die Steuersignalanschlüsse 19 der Leistungshalbleiter 18, 18A, 18B, 18C, 18D, 18E, 18F elektrisch mit der Auswerteund Steuereinheit 20 verbunden. Die drei Leistungsmodule 11A, 11B, 11C bilden jeweils eine vollständige B6-Brücke bzw. ein Invertersegment und stellen mit der Auswerte- und Steuereinheit 20 und den Kondensatoren 26, 26A, 26B einen kompletten Inverter dar. Die drei Leistungsmodule 11A, 11B, 11C stellen jeweils ein Invertersegment mit jeweils 40kW Leistungsaufnahme dar. Somit besitzt der Gesamtinverter eine Leistungsaufnahme von 120kW. Wie aus Fig. 4 weiter ersichtlich ist, umfasst die Auswerte- und Steuereinheit 20 einen Schaltungsträger 22 mit drei integrierten Schaltkreisen 24, welche jeweils als anwendungsspezifische integrierte Schaltungen 24A, 24B, 24C ausgeführt sind. Der Schaltungsträger 24 bietet zusätzliche Möglichkeiten zur Platzierung eines nicht dargestellten EMV-Filters am Gleichstromeingang. Die Anzahl der integrierten Schaltkreise 24 ist variabel je nach Anzahl der zusammengesteckten Leistungsmodule 11A, 11B, 11C bzw. Invertersegmente.

Wie aus Fig. 6 ersichtlich ist, umfasst das dargestellte Ausführungsbeispiel eines Fahrzeug 1 eine Leistungselektronik 10, welche beispielsweise der oben beschriebenen Leistungselektronik 10 mit drei Leistungsmodulen 11, 11A, 11B, 11C entspricht, und einen Kühlkreislauf 1A, in welchem zur Kühlung von Fahrzeugaggregaten ein dielektrisches Fluid geführt ist. Die Leistungselektronik 10 ist über korrespondierende Schnittstelleneinheiten 28 fluidisch mit dem Kühlkreislauf 1A verbunden. Zur Realisierung einer komplett durch ein dielektrisches Fluid gekühlten elektrischen Antriebsachse sind parallel zur Leistungselektronik 10 ein elektrischer Antrieb 2 und ein Getriebe 3 fluidisch mit dem Kühlkreislauf 1A verbunden. Nach den zu kühlenden Komponenten wird das dielektrische Fluid in einem Fluidsammelbehälter 7 gesammelt und anschließend durch einen Fluidfilter 8 von einer Fluidpumpe 9 angesaugt. Nach der Fluidpumpe 9 wird das dielektrische Fluid in einem Wärmeübertrager 4 gekühlt, beispielsweise durch ein Wasser/Glykol-Gemisch. Zur gezielten Temperatursteuerung des dielektrischen Fluids ist auch eine gepunktet dargestellte Umgehung 7 bzw. ein Bypass zum Wärmeübertrager 4 möglich.

## Patentansprüche

1. Leistungsmodul (11), insbesondere für eine Leistungselektronik (10) eines Fahrzeugs (1), mit zwei Gleichstromstromschienen (12, 14) und drei Phasenstromschienen (16), welche zwischen den beiden Gleichstromschienen (12, 14) angeordnet sind, und mehreren Leistungshalbleitern (18), welche jeweils zwischen einer der Gleichstromschienen (12, 14) und einer der Phasenstromschienen (16) angeordnet sind, wobei die Gleichstromstromschienen (12, 14) und die Phasenstromschienen (16) gegeneinander elektrisch isoliert sind und jeweils mindestens einen von einem dielektrischen Fluid durchströmten Kühlkanal (13, 15, 17) aufweisen, **dadurch gekennzeichnet, dass** die Gleichstromstromschienen (12, 14) und die Phasenstromschienen (16) an beiden offenen Enden jeweils mindestens einen steckbaren elektrischen Kontaktanschluss (12.1, 14.1, 16.1) und mindestens einen steckbaren Fluidanschluss (13.1, 15.1, 17.1) aufweisen, welche jeweils einen kombinierten Steckverbindungsanschluss ausbilden, so dass mehrere Leistungsmodule (11) mittels Steckverbindungen fluiddicht miteinander verbindbar sind.

2. Leistungsmodul (11) nach Anspruch 1, **dadurch gekennzeichnet, dass** die einzelnen Leistungshalbleiter (18) als Halbleiterschalter ausgeführt sind, wobei jeweils ein erster Leistungsanschluss der Leistungshalbleiter (18) direkt mit einer korrespondierenden Gleichstromstromschiene (12, 14) und ein zweiter Leistungsanschluss der Leistungshalbleiter (18) über einen Abstandshalter mit einer korrespondierenden Phasenstromschiene (16) verbunden ist.

3. Leistungsmodul (11) nach Anspruch 1 oder 2, **dadurch gekennzeichnet, dass** die Gleichstromstromschienen (12, 14) jeweils drei Kühlkanäle (13, 15) aufweisen, welche jeweils parallel zu den Kühlkanälen (17) der drei Phasenstromschienen (16) verlaufen.

4. Leistungsmodul (11) nach Anspruch 2 und 3, **dadurch gekennzeichnet, dass** ein erster Leistungshalbeiter (18A) zwischen einem ersten Kühlkanal (13A) einer ersten Gleichstromstromschiene (12) und dem Kühlkanal (17) einer ersten Phasenstromschiene (16A) angeordnet ist, wobei ein zweiter Leistungshalbeiter (18B) zwischen einem ersten Kühlkanal (15A) einer zweiten Gleichstromstromschiene (14) und dem Kühlkanal (17) der ersten Phasenstromschiene (16A) angeordnet ist, wobei ein dritter Leistungshalbeiter (18C) zwischen einem zweiten Kühlkanal (13B) der ersten Gleichstromstromschiene (12) und dem Kühlkanal (17) einer zweiten Phasenstromschiene (16B) angeordnet ist, wobei ein vierter Leistungshalbeiter (18D) zwischen einem zweiten Kühlkanal (15B) der zweiten Gleichstromstromschiene (14) und dem Kühlkanal (17) der zweiten Phasenstromschiene (16A) angeordnet ist, wobei ein fünfter Leistungshalbeiter (18E) zwischen einem dritten Kühlkanal (13C) der ersten Gleichstromstromschiene (12) und dem Kühlkanal (17) einer dritten Phasenstromschiene (16C) angeordnet ist, wobei ein sechster Leistungshalbeiter (18F) zwischen einem dritten Kühlkanal (15C) der zweiten Gleichstromstromschiene (14) und dem Kühlkanal (17) der dritten Phasenstromschiene (16C) angeordnet ist.

5. Leistungsmodul (11) nach einem der Ansprüche 1 bis 4, **dadurch gekennzeichnet, dass** die einzelnen Kühlkanäle (13, 15, 17) im Bereich der Leistungshalbleiter (18) jeweils eine Kühlgeometrie (17.1) aufweisen.

6. Leistungsmodul (11) nach Anspruch 5, **dadurch gekennzeichnet, dass** die Kühlgeometrie (17.1) mehrere Kühlstifte (17.1A) oder Turbulatoren oder Vorsprünge oder Rippen umfasst.

7. Leistungsmodul (11) nach einem der Ansprüche 1 bis 6, **dadurch gekennzeichnet, dass** die Gleichstromstromschienen (12, 14) und die Phasenstromschienen (16) unter Freilassung der steckbaren Fluidanschlüsse (13.1, 15.1, 17.1) und der steckbaren elektrischen Kontaktanschlüsse (12.1, 14.1, 16.1) von einer Umhüllung (UH1) umgeben sind.

8. Leistungsmodul (11) nach Anspruch 7, **dadurch gekennzeichnet, dass** seitlich an den Gleichstromstromschienen (12, 14) Kondensatoranschlüsse (KA) angeordnet und aus der Umhüllung (UH1) herausgeführt sind, welche mit Kondensatoren (26) kontaktiert sind, so dass die einzelnen Kondensatoren (26) elektrisch jeweils zwischen den beiden Gleichstromschienen (12, 14) angeordnet sind.

9. Leistungsmodul (11) nach Anspruch 7 oder 8, **dadurch gekennzeichnet, dass** Steuersignalanschlüsse (19) der Leistungshalbleiter (18) seitlich aus der Umhüllung (UH1) herausgeführt sind, welche mit einer Auswerte- und Steuereinheit (20) kontaktierbar sind.

10. Leistungsmodul (11) nach Anspruch 8 und 9, **dadurch gekennzeichnet, dass** die seitlich angeordneten Kondensatoranschlüsse (KA) und die seitlich angeordneten Steuersignalanschlüsse (19) in einer gemeinsamen Anschlussebene angeordnet sind.

11. Leistungsmodul (11) nach einem der Ansprüche 1 bis 10, **dadurch gekennzeichnet, dass** die Gleichstromstromschienen (12, 14) und die Phasenstromschienen (16) als 3D-Druckbauteile oder als Stanz-Biegeteile ausgeführt sind.

12. Leistungselektronik (10) für ein Fahrzeug (1), mit einer Auswerte- und Steuereinheit (20) und mindestens einem Leistungsmodul (11), welches nach einem der Ansprüche 1 bis 11 ausgeführt ist, wobei die Steuersignalanschlüsse (19) der Leistungshalbleiter (18) elektrisch mit der Auswerte- und Steuereinheit (20) verbunden sind.

13. Leistungselektronik (10) nach Anspruch 12, **dadurch gekennzeichnet, dass** mehrere Leistungsmodule (11), welche jeweils ein Invertersegment ausbilden, durch Steckerbindungen miteinander verbunden sind und einen Gesamtinverter mit einer höheren Leistungsdichte ausbilden.

14. Fahrzeug (1) mit einer nach Anspruch 12 oder 13 ausgeführten Leistungselektronik (10) und einem Kühlkreislauf (1A), in welchem zur Kühlung von Fahrzeugaggregaten ein dielektrisches Fluid geführt ist, wobei die Leistungselektronik (10) über korrespondierende Schnittstelleneinheiten (28) fluidisch mit dem Kühlkreislauf (1A) verbunden ist.

## Claims

1. Power module (11), in particular for power electronics (10) of a vehicle (1), having two DC busbars (12, 14) and three phase busbars (16), which are arranged between the two DC busbars (12, 14), and a plurality of power semiconductors (18), which are each arranged between one of the DC busbars (12, 14) and one of the phase busbars (16), wherein the DC busbars (12, 14) and the phase busbars (16) are electrically insulated from each other and each have at least one cooling channel (13, 15, 17) through which a dielectric fluid flows, **characterized in that** the DC busbars (12, 14) and the phase busbars (16) each have at both open ends at least one pluggable electrical contact terminal (12.1, 14.1, 16.1) and at least one pluggable fluid terminal (13.1, 15.1, 17.1), which in each case form a combined plug connection terminal, such that a plurality of power modules (11) are able to be connected to each other in a fluid-tight manner by means of plug connections.

2. Power module (11) according to Claim 1, **characterized in that** the individual power semiconductors (18) are designed as semiconductor switches, wherein in each case a first power terminal of the power semiconductors (18) is connected to a corresponding DC busbar (12, 14) directly and a second power terminal of the power semiconductors (18) is connected to a corresponding phase busbar (16) via a spacer.

3. Power module (11) according to Claim 1 or 2, **characterized in that** the DC busbars (12, 14) each have three cooling channels (13, 15), which each run parallel to the cooling channels (17) of the three phase busbars (16).

4. Power module (11) according to Claims 2 and 3, **characterized in that** a first power semiconductor (18A) is arranged between a first cooling channel (13A) of a first DC busbar (12) and the cooling channel (17) of a first phase busbar (16A), wherein a second power semiconductor (18B) is arranged between a first cooling channel (15A) of a second DC busbar (14) and the cooling channel (17) of the first phase busbar (16A), wherein a third power semiconductor (18C) is arranged between a second cooling channel (13B) of the first DC busbar (12) and the cooling channel (17) of a second phase busbar (16B), wherein a fourth power semiconductor (18D) is arranged between a second cooling channel (15B) of the second DC busbar (14) and the cooling channel (17) of the second phase busbar (16A), wherein a fifth power semiconductor (18E) is arranged between a third cooling channel (13C) of the first DC busbar (12) and the cooling channel (17) of a third phase busbar (16C), wherein a sixth power semiconductor (18F) is arranged between a third cooling channel (15C) of the second DC busbar (14) and the cooling channel (17) of the third phase busbar (16C).

5. Power module (11) according to one of Claims 1 to 4, **characterized in that** the individual cooling channels (13, 15, 17) each have a cooling geometry (17.1) in the region of the power semiconductors (18).

6. Power module (11) according to Claim 5, **characterized in that** the cooling geometry (17.1) comprises a plurality of cooling pins (17.1 A) or turbulators or projections or fins.

7. Power module (11) according to one of Claims 1 to 6, **characterized in that** the DC busbars (12, 14) and the phase busbars (16) are surrounded by a covering (UH1) while leaving the pluggable fluid terminals (13.1, 15.1, 17.1) and the pluggable electrical contact terminals (12.1, 14.1, 16.1) free.

8. Power module (11) according to Claim 7, **characterized in that** capacitor terminals (KA) are arranged on the side of the DC busbars (12, 14) and led out of the covering (UH1), which capacitor terminals come into contact with capacitors (26), such that the individual capacitors (26) are each electrically arranged between the two DC busbars (12, 14).

9. Power module (11) according to Claim 7 or 8, **characterized in that** control signal terminals (19) of the power semiconductors (18) are led out from the side of the covering (UH1), which control signal terminals are able to come into contact with an evaluation and control unit (20).

10. Power module (11) according to Claims 8 and 9, **characterized in that** the laterally arranged capacitor terminals (KA) and the laterally arranged control signal terminals (19) are arranged in a common terminal plane.

11. Power module (11) according to one of Claims 1 to 10, **characterized in that** the DC busbars (12, 14) and the phase busbars (16) are designed as 3D printed components or as stamped-bent parts.

12. Power electronics (10) for a vehicle (1), having an evaluation and control unit (20) and at least one power module (11), which is designed according to one of Claims 1 to 11, wherein the control signal terminals (19) of the power semiconductors (18) are electrically connected to the evaluation and control unit (20).

13. Power electronics (10) according to Claim 12, **characterized in that** a plurality of power modules (11), which each form an inverter segment, are connected to each other by plug connections and form an overall inverter having a higher power density.

14. Vehicle (1) having power electronics (10) designed according to Claim 12 or 13 and a cooling circuit (1A) through which a dielectric fluid is conducted in order to cool vehicle units, wherein the power electronics (10) are fluidly connected to the cooling circuit (1A) via corresponding interface units (28).

## Revendications

1. Module de puissance (11), en particulier pour une électronique de puissance (10) d'un véhicule (1), comprenant deux barres omnibus à courant continu (12, 14) et trois barres omnibus de phase (16), qui sont agencées entre les deux barres omnibus à courant continu (12, 14), et plusieurs semi-conducteurs de puissance (18), lesquels sont chacun agencés entre l'une des barres omnibus à courant continu (12, 14) et l'une des barres omnibus de phase (16), les barres omnibus à courant continu (12, 14) et les barres omnibus de phase (16) étant isolées électriquement les unes des autres et présentant chacune au moins un canal de refroidissement (13, 15, 17) à travers lequel s'écoule un fluide diélectrique, **caractérisé en ce que** les barres omnibus à courant continu (12, 14) et les barres omnibus de phase (16) présentent chacune au niveau des deux extrémités ouvertes au moins une connexion de contact électrique enfichable (12.1, 14.1, 16.1) et au moins une connexion fluidique enfichable (13.1, 15.1, 17.1), lesquelles forment chacune une connexion enfichable combinée, de sorte que plusieurs modules de puissance (11) peuvent être connectés les uns aux autres de manière étanche au fluide au moyen de connexions à fiches.

2. Module de puissance (11) selon la revendication 1, **caractérisé en ce que** les semi-conducteurs de puissance (18) individuels sont réalisés sous forme d'interrupteurs à semi-conducteurs, une première connexion de puissance des semi-conducteurs de puissance (18) étant directement reliée à une barre omnibus à courant continu (12, 14) correspondante et une deuxième connexion de puissance des semi-conducteurs de puissance (18) étant reliée à une barre omnibus de phase (16) correspondante par l'intermédiaire d'un espaceur.

3. Module de puissance (11) selon la revendication 1 ou 2, **caractérisé en ce que** les barres omnibus à courant continu (12, 14) présentent chacune trois canaux de refroidissement (13, 15), lesquels s'étendent chacun parallèlement aux canaux de refroidissement (17) des trois barres omnibus de phase (16).

4. Module de puissance (11) selon les revendications 2 et 3, **caractérisé en ce qu'**un premier semi-conducteur de puissance (18A) est agencé entre un premier canal de refroidissement (13A) d'une première barre omnibus à courant continu (12) et le canal de refroidissement (17) d'une première barre omnibus de phase (16A), un deuxième semi-conducteur de puissance (18B) étant agencé entre un premier canal de refroidissement (15A) d'une deuxième barre omnibus à courant continu (14) et le canal de refroidissement (17) de la première barre omnibus de phase (16A), un troisième semi-conducteur de puissance (18C) étant agencé entre un deuxième canal de refroidissement (13B) de la première barre omnibus à courant continu (12) et le canal de refroidissement (17) d'une deuxième barre omnibus de phase (16B), un quatrième semi-conducteur de puissance (18D) étant agencé entre un deuxième canal de refroidissement (15B) de la deuxième barre omnibus à courant continu (14) et le canal de refroidissement (17) de la deuxième barre omnibus de phase (16B), un cinquième semi-conducteur de puissance (18E) étant agencé entre un troisième canal de refroidissement (13C) de la première barre omnibus à courant continu (12) et le canal de refroidissement (17) d'une troisième barre omnibus de phase (16C), un sixième semi-conducteur de puissance (18F) étant agencé entre un troisième canal de refroidissement (15C) de la deuxième barre omnibus à courant continu (14) et le canal de refroidissement (17) de la troisième barre omnibus de phase (16C).

5. Module de puissance (11) selon l'une quelconque des revendications 1 à 4, **caractérisé en ce que** les canaux de refroidissement (13, 15, 17) individuels présentent chacun une géométrie de refroidissement (17.1) dans la zone des semi-conducteurs de puissance (18).

6. Module de puissance (11) selon la revendication 5, **caractérisé en ce que** la géométrie de refroidissement (17.1) comprend plusieurs broches de refroidissement (17.1 A) ou des turbulateurs ou des protubérances ou des nervures.

7. Module de puissance (11) selon l'une quelconque des revendications 1 à 6, **caractérisé en ce que** les barres omnibus à courant continu (12, 14) et les barres omnibus de phase (16) sont entourées d'une enveloppe (UH1), en laissant libres les connexions fluidiques enfichables (13.1, 15.1, 17.1) et les connexions de contact électriques enfichables (12.1, 14.1, 16.1).

8. Module de puissance (11) selon la revendication 7, **caractérisé en ce que** des connexions de condensateur (KA) sont agencées latéralement sur les barres omnibus à courant continu (12, 14) et sont sorties de l'enveloppe (UH1), lesquelles sont en contact avec des condensateurs (26), de sorte que les condensateurs (26) individuels sont chacun agencés électriquement entre les deux barres omnibus à courant continu (12, 14).

9. Module de puissance (11) selon la revendication 7 ou 8, **caractérisé en ce que** des connexions de signal de commande (19) des semi-conducteurs de puissance (18) sont sorties latéralement de l'enveloppe (UH1), lesquelles peuvent être mises en contact avec une unité d'évaluation et de commande (20).

10. Module de puissance (11) selon la revendication 8 et 9, **caractérisé en ce que** les connexions de condensateur (KA) agencées latéralement et les connexions de signal de commande (19) agencées latéralement sont agencées dans un plan de connexion commun.

11. Module de puissance (11) selon l'une quelconque des revendications 1 à 10, **caractérisé en ce que** les barres omnibus à courant continu (12, 14) et les barres omnibus de phase (16) sont réalisées sous forme de composants imprimés en 3D ou sous forme de pièces estampées-pliées.

12. Électronique de puissance (10) pour un véhicule (1), comprenant une unité d'évaluation et de commande (20) et au moins un module de puissance (11), lequel est réalisé selon l'une quelconque des revendications 1 à 11, les connexions de signal de commande (19) des semi-conducteurs de puissance (18) étant reliées électriquement à l'unité d'évaluation et de commande (20).

13. Électronique de puissance (10) selon la revendication 12, **caractérisée en ce que** plusieurs modules de puissance (11), qui forment chacun un segment d'onduleur, sont reliés les uns aux autres par des raccords enfichables et forment un onduleur global ayant une densité de puissance plus élevée.

14. Véhicule (1) comprenant une électronique de puissance (10) réalisée selon la revendication 12 ou 13 et un circuit de refroidissement (1A), dans lequel un fluide diélectrique est acheminé pour le refroidissement d'équipements de véhicule, l'électronique de puissance (10) étant reliée fluidiquement au circuit de refroidissement (1A) par l'intermédiaire d'unités d'interface (28) correspondantes.
